# EUROPEAN PATENT SPECIFICATION

(11) **EP 1 675 266 B1**
(45) Date of publication and mention of the grant of the patent: **10.03.2010**
(21) Application number: 05107860.8
(22) Date of filing: 26.08.2005
(51) Int. Cl.: H03K 23/66, H03K 23/58

(54) **An improved area efficient programmable frequency divider**
Flächeneffizienter programmierbarer Frequenzteiler
Diviseur de fréquence programmable utilisant la surface de façon efficace

(30) Priority: 27.08.2004 IN DE16292004
(43) Date of publication of application: 28.06.2006
(73) Proprietor: STMicroelectronics Pvt. Ltd, Noida-201 301, Uttar Pradesh (IN)
(72) Inventor: Chatterjee, Kallol, Calcutta, West Bengal (IN); Jain, Deependra, 483220, Panagar, District Jabalpur (IN)
(74) Representative: Bosotti, Luciano

(56) References cited:
- LARSSON P: "HIGH-SPEED ARCHITECTURE FOR A PROGRAMMABLE FREQUENCY DIVIDER AND A DUAL-MODULUS PRESCALER" IEEE JOURNAL OF SOLID-STATE CIRCUITS, IEEE SERVICE CENTER, PISCATAWAY, NJ, US, vol. 31, no. 5, 1 May 1996 (1996-05-01), pages 744-748, XP000597248 ISSN: 0018-9200

## Description

### Field of the Invention

The present invention relates to an improved area efficient programmable frequency divider capable of programming the dividing ratio of an input clock frequency.

### Background of the Invention

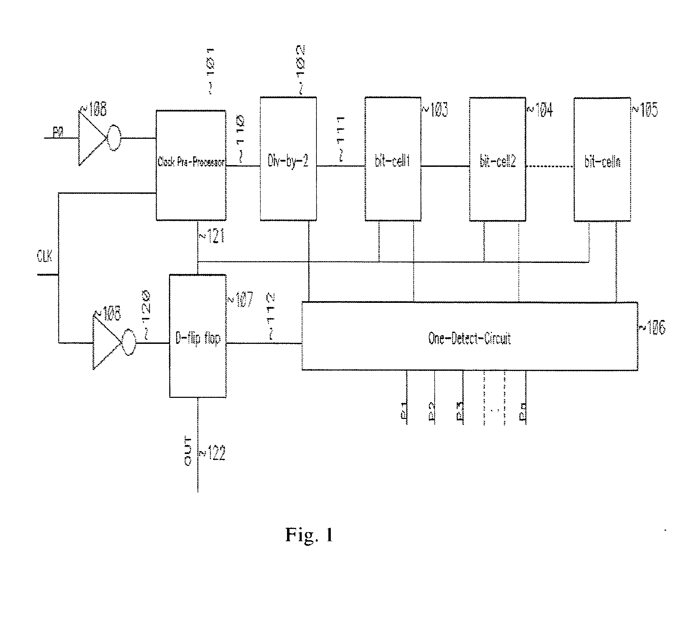

In recent years, attention has been given to asynchronous frequency divider to achieve high speed and low power requirements. For example, paper published by Patrik Larsson, published on IEEE Journal of solid-state circuit, Vol 31, no 5, May 1996. This frequency divider is shown in fig 1.

Figure 1 shows a frequency divider with a clock pre-processor circuit (101) to block the clock for odd division; a divide-by-2 circuit (102), which divides input clock frequency by a factor of 2; a series of identical bit-cells (103, 104 and the like), one detect circuit (106), which detects whether all stages are at logic-high state and a D-flip flop (107).

The input clock CLK is applied to a clock pre-processor circuit (101) and D flip-flop (107) via an inverter (108). The output (110) of the pre-processor circuit (101) is passed to a divide-by-2 block (102). The Q-output (111) of divide-by-2 circuit (102) is connected to the input of first bit-cell (103).

Each bit-cell has two outputs viz. CLKi and OUTi. The first output OUTi of each bit-cell and QN of divide-by-2 block (102) is fed to one-detect-circuit (106) while the second input CLKi of each bit-cell is fed to input clock of next bit-cell.

The one-detect-circuit (106) has two sets of inputs. First set of inputs is the data inputs (P1 to Pn) while the second set of inputs are formed by the bit-cell's OUTi outputs. The first set of inputs is used to determine the bits to be used from the second set of inputs for determination of the output state of one-detect-circuit (106). The one-detect-circuit (106) starts detection of the state of data input starting from MSB data input. As soon as it encounters first logic-high data input it logically ANDs the OUTi outputs of bit-cells numbered from said data input to the remaining data inputs i.e. LSB data input to get final output of one-detect-circuit (106). If all the data inputs (P1 to Pn) are at logic-low state then the output of one-detect-circuit (106) will be at the same state as that of QN of divide-by-2 block (102).

The one-detect-circuit (106) outputs a logic-high signal when output OUTi of each bit-cell and output QN of divide-by-2 block (102) are at logic-high state. The output of one-detect-circuit (106) is fed to the input of a D flip-flop (107). The D flip-flop (107) receives its clock from an inverter (108), thereby getting an inverted input clock.

A standard D-flip flop (107) is used in this counter. It has one data-input, one clock-input, two outputs, viz. D, CLK, Q, and QN respectively. The output of one-detect-circuit (106) is connected to D input of D-flip flop (107). The input clock to the frequency divider is inverted and this output (120) is fed to the CLK input of the D-flip flop (107). The QN output of D-flip flop (121) is connected to the CLK_BLOCK input of the clock-pre-processor circuit. The D-flip flop's Q output (122) is also destined to final output pin of the counter. LSB of input data bits P0 is inverted and connected to POBAR input of clock pre-processor circuit.

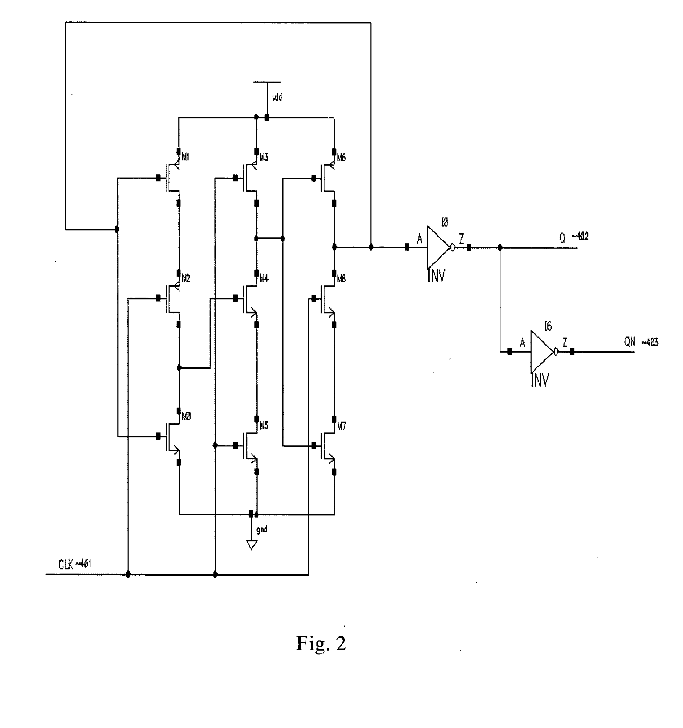

Figure 2 shows the construction of divide-by-2 block. Divide-by-2 block has one CLK input (401) and two outputs viz. Q (402) and QN (403). It divides the input clock frequency by a factor of 2.

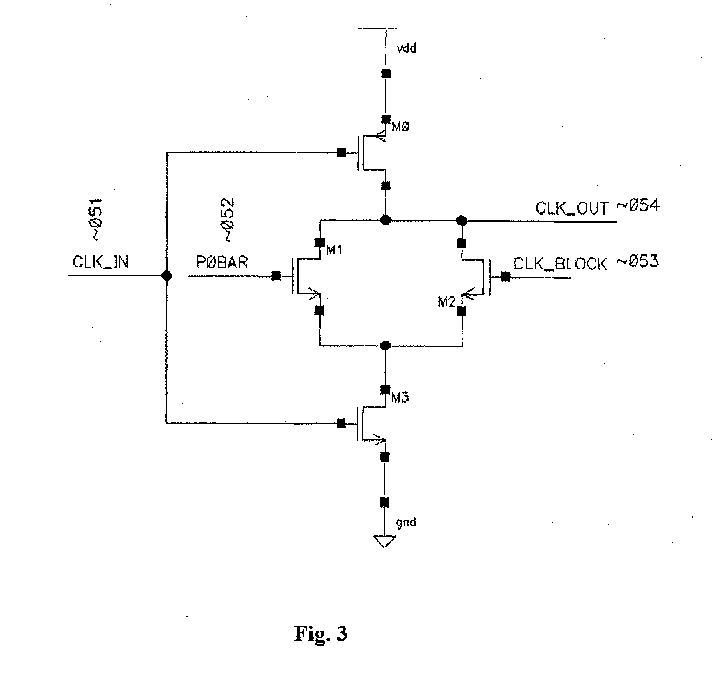

Figure 3 shows a clock pre-processor circuit. The circuit has two control inputs, one clock input and one clock output. The control inputs of the circuit are POBAR (052) and CLK_BLOCK (053) while CLK_IN (051) is the input clock and CLK_OUT (054) is the output clock that is fed to divide-by-2 block (102). When both the control inputs of clock pre-processor circuit are logic-low, its output is logic-high. But when any of the control inputs is logic-high, the output of clock preprocessor circuit is the inverted value of the input clock.

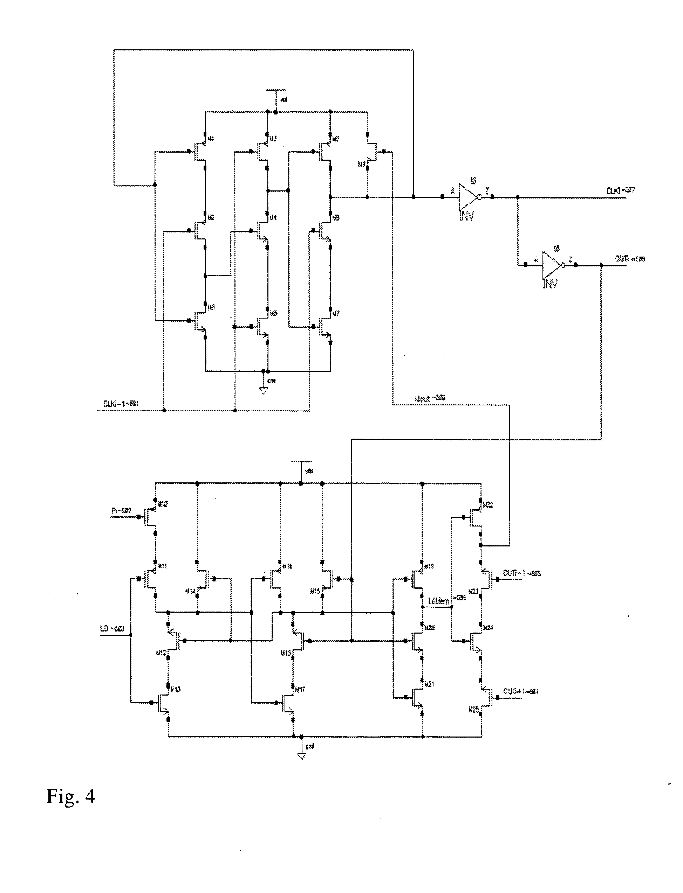

Figure 4 expands the bit-cell circuit. It comprises of five inputs viz. CLKi-1 (501), Pi (502), LD (503), CLKi+1(504), OUTi-1 (505) and two outputs viz. CLKi (507) and OUTi (508). CLKi+1(504) is connected to CLKi of next stage bit-cell, while CLKi-1 (501) is connected to CLKi of previous stage bit-cell. Similarly, OUTi-1 (505) is connected to OUTi of previous stage bit-cell.

Within the bit-cell there is a net named LdMem (509). Whenever there is logic-low at Pi, logic-low at LD, and logic-high at OUTi then LdMem goes logic-high. When CLKi+1 and OUTi-1 go high then net 1dout (506) goes logic-low, which in turn forces CLKi to logic-low and OUTi to logic-high state. As OUTi goes logic-high, LdMem goes logic-low, which in turn forces ldout to logic-high. In normal conditions, when LdMem is at logic-low state, bit-cell works as divide-by-2 circuit. It divides the input clock frequency at CLKi-1 by a factor of 2 and gives the output at CLKi and OUTi.

However, according to the structure of a prior art frequency divider, if Q of first divde-by-2 (102) is at logic-low, output of clock pre-processor (110) is at logic-high and all the control inputs of clock pre-processor circuit are at logic-low state, then it will get stuck in that state and can never come out. Apart from that, architecture of bit-cell circuit is also complex in order to latch Ldout signal.

### Objects And Summary Of The Invention

To solve the above-mentioned problems, it is an object of the present invention to provide a programmable high-speed frequency divider with simplified bit-cell circuit without loss of implied circuitry function and the operating speed.
Another object of the invention is to ensure that the frequency-divider does not go into false state.

Yet another object of the invention is to generate load signal for individual stage using a global signal, which is generated for more than one clock cycles.

To achieve said objects the instant invention provides an improved area efficient programmable frequency divider comprising:
- a clock-preprocessor circuit for processing the input clock and blocking one cycle in case of odd frequency division;
- a divide-by-two block connected to the output of said clock-pre-processor circuit for dividing the input frequency to half its value;
- a series of bit-cells connected to each other, each having a simplified loading circuit with the clock of first bit cell connected to the output of said divide-by-2 block;
- a logic detection circuit receiving inputs from each of said bit-cells and said divide-by-two block; and
- a synchronizing element connected to the output of said logic detection circuit to generate a synchronized divider output;
characterized in that it includes
- an additional synchronizing element connected to the output of said one-detect-circuit, receiving its clock from the output of said divide-by-two block and generating a special synchronized load output; and
- a plurality of combinational logic blocks receiving said load output and generating load signals for said bit-cells for detecting the state of all the stages.

The said clock-pre-processor circuit includes a startup transistor connected in parallel to the control transistors to ensure said divider does not go in false state.

The said bit cells comprise of:
- a divide-by-two circuit; and
- plurality of transistors connected to the divide-by-two circuit for loading the bit cells
thereby loading divided frequency when the load signal is inactive while loading high logic when said signal is active at the output of said bit cells.

The said combinational logic generates a load signal for each said bit-cell using a global signal, which is generated for more than one input clock cycles.

### Brief Description of The Accompanying Drawings:

The objects and advantages of the present invention will become more apparent by describing in detail-preferred embodiments thereof with reference to the accompanying drawings.

FIG. 1 is a schematic diagram of a prior art programmable frequency divider.

FIG. 2 is a circuit diagram of divide-by-2 circuit of prior art programmable frequency divider.

FIG. 3 is a circuit diagram of clock pre-processor circuit of prior art programmable frequency divider;

FIG. 4 is a circuit diagram of bit-cell circuit of prior art programmable frequency divider.

FIG. 5 is a schematic diagram of a preferred embodiment of a programmable high-speed frequency divider according to the present invention.

FIG. 6 is a circuit diagram of Clock pre-processor circuit of programmable high-speed frequency divider according to the present invention.

FIG. 7 is a circuit diagram of Bit-cell circuit of programmable high-speed frequency divider according to the present invention.

FIG. 8 is a logic diagram of LD_block circuit of programmable high-speed frequency divider according to the present invention.

### Detailed Description Of The Invention

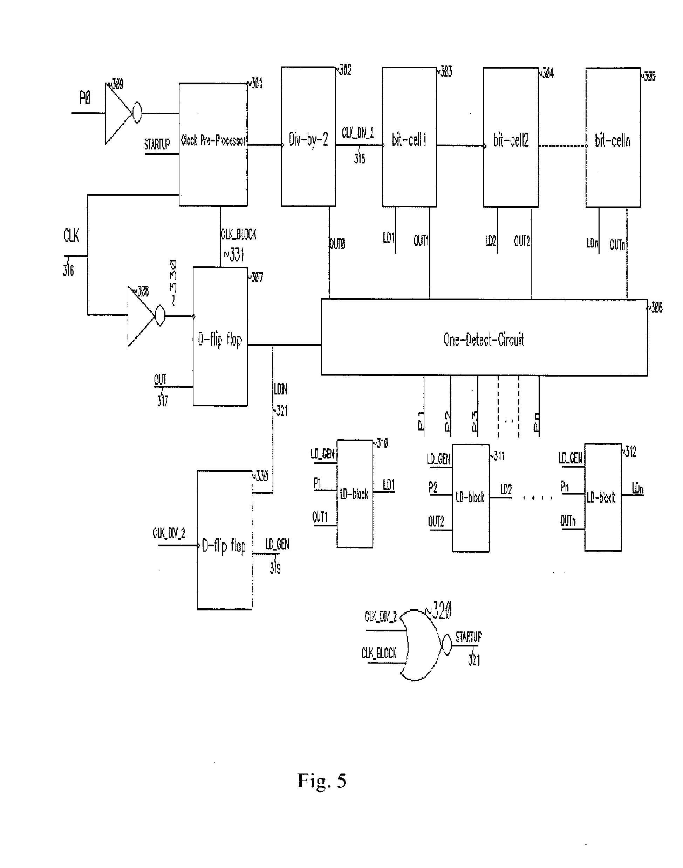

A preferred embodiment of present invention will be described with respect to drawing. Referring to fig. 5, frequency divider has a clock pre-processor circuit (301) to block the clock for odd division; a divde-by-2 circuit (302), which divides input clock frequency by a factor of 2; a series of identical bit-cells (303, 304 and the like), which is normal div-by-2 circuit with a load input; one-detect-circuit (306), which detects whether all stages are at logic-high state; 2 D-flip flops (307 and 330) and identical LD-blocks (310, 311, 312).

Divide-by-2 circuit (302) divides frequency of input signal at CLK by 2 and gives the output at OUTi and CLKi, which are logically inverted to each other.

The final output LDIN (321) of one-detect-circuit (306) is fed to the D-input of the two D-flip flops (307 and 330).

Two standard D-flip flops (307 and 330) are used in the counter. Each flip-flop has one data-input, one clock-input, two outputs, viz. D, CLK, Q, and QN respectively. Both D-flip flops (307 and 330) have LDIN (321) at their D input. The input clock to the frequency divider is inverted and is fed to the CLK input of the first D-flip flop (307). CLK input of second D-flip flop (330), CLK_DIV_2 (315) is connected to CLKi output of Divde-by-2 circuit. The QN output of first D-flip flop (331) is connected to the CLK_BLOCK input of the clock-pre-processor circuit. First D-flip flop's Q output (317) is also destined to final output pin of the counter. Q output of second D-flip flop is LD_GEN (319), which is connected to all LD_blocks to generate load signal for each bit-cell.

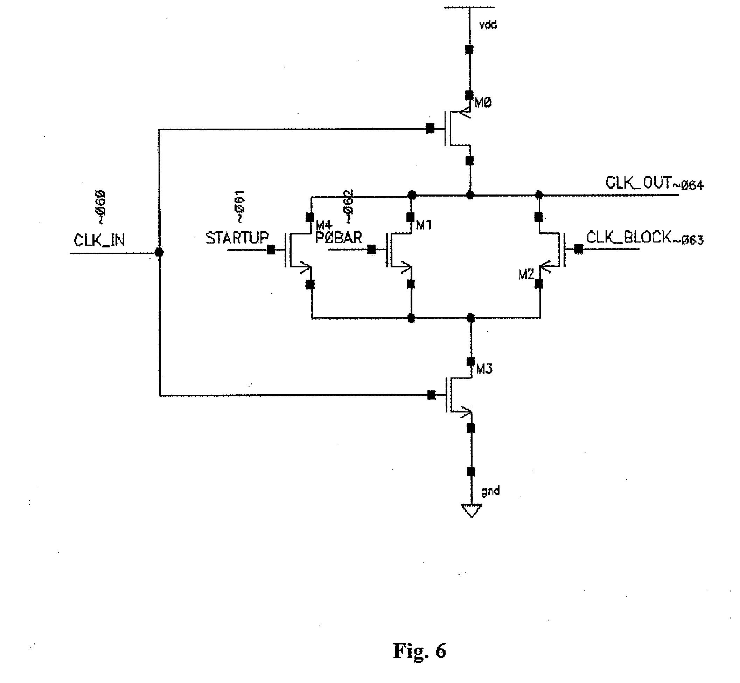

Figure 6 shows the clock pre-processor circuit (301). The circuit has three control inputs, one clock input and one clock output. The control inputs of the clock pre processor circuit are POBAR (062), STARTUP (061) and CLK_BLOCK (063) while CLK_IN (060) is the input clock and CLK_OUT (064) is the output clock, which is fed to divide-by-2 block. When all the control inputs of clock pre-processor circuit are at logic-low then its output is at logic-high state. But if any of the control inputs are at logic-high, the output of clock pre-processor circuit is the inverted value of the input clock.

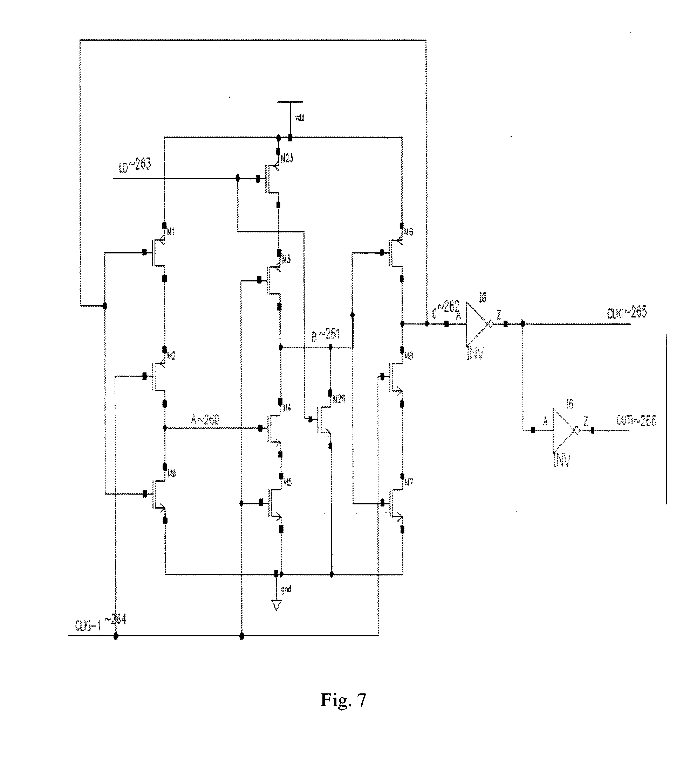

Figure 7 shows the bit-cell circuit. CLKi-1 (264) and LD (263) are the two inputs while CLKi (265) and OUTi (266) are the two outputs. CLKi-1 (264) is connected to CLKi of previous stage bit-cell. In normal conditions, when LD is at logic-low state, bit-cell works as divide-by-2 circuit. It divides the input clock frequency at CLKi-1 by a factor of 2 and gives the output at CLKi and OUTi, which are logically inverted to each other. When LD is at logic-high state, OUTi is forced to be at logic-high and CLKi to be at logic-low. Each bit-cell divides the clock fed to it by a factor of 2 when the load signal is inactive. When load signal is active, it loads logic-high to bit-cell output, irrespective of input clock.

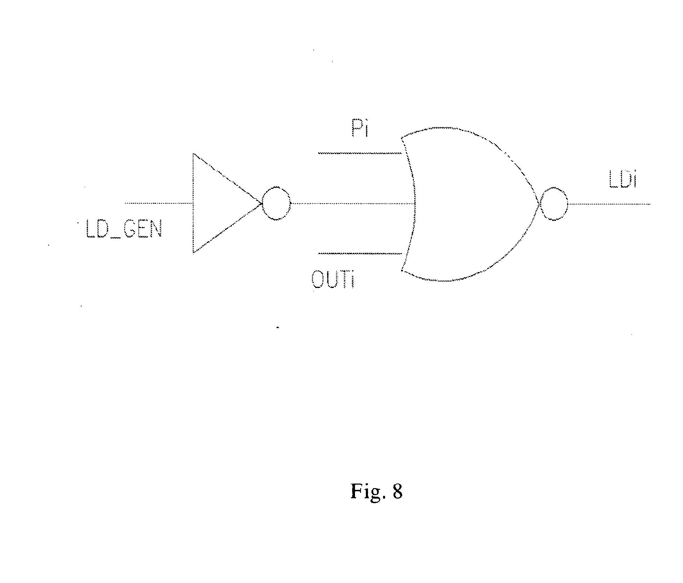

Fig 8 shows LD_block used to generate load signal for each bit-cell. It has three inputs and one output. It has Pi, OUTi and LD_GEN as inputs and one LDi output. If Pi and OUTi are at logic-low state and LD_GEN is at logic high state then LDi is at logic high state; otherwise it remains at logic low state. There is separate LD_block for each bit-cell. Pi input of each LD_block is connected to corresponding data input, OUTi input of each LD_block is connected to OUTi output of corresponding bit-cell and LD_GENi input is connected to LD_GEN output (319) of D-flip flop (330). LDi signal is connected to LD input of corresponding bit-cell.

As shown in fig 5, CLKi output of first divide-by-2, CLK_DIV_2 (315) and QN output of first D-flip flop (307), have been logically NORed to generate STARTUP signal (321). This STARTUP is connected to STARTUP input of clock pre-processor circuit.

Optimum embodiments have been explained in the drawings and specification, and though specific terminologies are used here, they are only used to explain the present invention. Therefore, the present invention is not restricted to the above-described embodiments and many variations are possible within the scope of the present invention. The scope of the present invention is not determined by the description but by the accompanying claims.

## Claims

1. An area efficient programmable frequency divider comprising:
- a clock-preprocessor circuit (301) for processing the input clock (P0) and blocking one cycle in case of odd frequency division;
- a divide-by-two block (302) connected to the output of said clock-preprocessor circuit (301) for dividing the input frequency to half its value;
- a series of bit-cells (303, 304, 305) connected to each other, each having a simplified loading circuit with the clock of first bit cell connected to the output (315) of said divide-by-2 block (302);
- a logic detection circuit (306) for receiving inputs from each of said bit-cells (303, 304, 305) and said divide-by-two block (302); and
- a synchronizing element (307) connected to the output of said logic detection circuit (306) to generate a synchronized divider output;
**characterized in that** it includes
- an additional synchronizing element (330) connected to the output of said logic detection circuit (307), for receiving its clock from the output of said divide-by-two block (302) and for generating a synchronized load output (319); and
- a plurality of combinational logic blocks (310, 311, 312) for receiving said load output (319) and for generating load signals (LD1, LD2, LDn) for said bit-cells (303, 304, 305) for detecting the state of all the stages.

2. An area efficient programmable frequency divider as claimed in claim 1 wherein said clock-pre-processor circuit (301) includes a startup transistor (M4) connected in parallel to the control transistors (M1) to ensure said divider does not go in false state.

3. An area efficient programmable frequency divider as claimed in claim 1 wherein said bit cells (303, 304, 305) comprise of:
- a divide-by-two circuit; and
- plurality of transistors connected to the divide-by-two circuit for loading the bit cells and where the bitcells are adapted for outputting the divided frequency if the load signal is inactive and for outputting a logic high signal if the load signal is active.

4. An area efficient programmable frequency divider as claimed in claim 1 wherein said combinational logic is designed for generating a load signal for each said bit-cell using a global signal, which is generated for more than one input clock cycles.

## Patentansprüche

1. Flächeneffizienter, programmierbarer Frequenzteiler, aufweisend:
- eine Takt-Präprozessor-Schaltung (301) zum Verarbeiten des Eingangstaktes (P0) und zum Blockieren eines Zyklus im Falle einer ungeradzahligen Frequenzteilung;
- ein mit dem Ausgang der Takt-Präprozessor-Schaltung (301) verbundener Halbierungs-Block (302) zum Teilen der Eingangsfrequenz auf die Hälfte ihres Wertes;
- eine Reihenschaltung von miteinander verbundenen Bit-Zellen (303, 304, 305), von denen jede eine vereinfachte Ladeschaltung aufweist, wobei der Takt der ersten Bit-Zelle mit dem Ausgang (315) des Halbierungs-Blockes (302) verbunden ist;
- eine Logikdetektionsschaltung (306) zum Entgegennehmen von Eingaben von jeder der Bit-Zellen (303, 304, 305) sowie von dem Halbierungs-Block (302); und
- ein mit dem Ausgang der Logikdetektionsschaltung (306) verbundenes Synchronisationselement (307) zum Erzeugen eines synchronisierten Teilerausganges;
**dadurch gekennzeichnet, dass** er aufweist:
- ein mit dem Ausgang der Logikdetektionsschaltung (307) verbundenes zusätzliches Synchronisierungselement (330) zum Entgegennehmen von dessen Takt aus dem Ausgang des Halbierungs-Blockes (302) und zum Erzeugen eines synchronisierten Lastausganges (319); und
- eine Mehrzahl von Schaltungslogikblöcken (310, 311, 312) zum Entgegennehmen des Lastausganges (319) und zum Erzeugen der Lastsignale (LD1, LD2, LDn) für die Bit-Zellen (303, 304, 305) zum Detektieren des Zustandes aller Stufen.

2. Flächeneffizienter programmierbarer Frequenzteiler nach Anspruch 1, wobei die Takt-Präprozessor-Schaltung (301) einen mit Steuerungstransistoren (M1) parallel geschalteten Anlauf-Transistor (M4) zum Sicherstellen, dass der Teiler nicht in einen unrichtigen Zustand gerät, aufweist.

3. Flächeneffizienter programmierbarer Frequenzteiler nach Anspruch 1, wobei die Bit-Zellen (303, 304, 305) umfassen:
- eine Halbierer-Schaltung; und
- eine Mehrzahl von mit der Halbierer-Schaltung verbundener Transistoren zum Laden der Bit-Zellen,
- und wobei die Bit-Zellen eingerichtet sind zum Ausgeben der geteilten Frequenz, wenn das Lastsignal inaktiv ist, und zum Ausgeben eines hohen Logiksignals, wenn das Lastsignal aktiv ist.

4. Flächeneffizienter programmierbarer Frequenzteiler nach Anspruch 1, wobei die Schaltungslogik zum Erzeugen eines Lastsignals für jede Bit-Zelle unter Verwendung eines globalen Signals, welches für mehr als einen Eingangstaktzyklus generiert wird, konstruiert ist.

## Revendications

1. Diviseur de fréquence programmable optimisant la surface comprenant :
- un circuit préprocesseur d'horloge (301) pour traiter l'horloge d'entrée (P0) et bloquer un cycle dans le cas d'une division de fréquence impaire ;
- un bloc de division par deux (302) connecté à la sortie dudit circuit préprocesseur d'horloge (301) pour diviser la fréquence d'entrée à la moitié de sa valeur ;
- une série de cellules binaires (303, 304, 305) connectées entre elles, chacune ayant un circuit de charge simplifié avec l'horloge de la première cellule binaire connectée à la sortie (315) dudit bloc de division par deux (302) ;
- un circuit de détection logique (306) destiné à recevoir des entrées de chacune desdites cellules binaires (303, 304, 305) et dudit bloc de division par deux (302) ; et
- un élément de synchronisation (307) connecté à la sortie dudit circuit de détection logique (306) pour produire une sortie de diviseur synchronisée ;
**caractérisé en ce qu'**il comprend :
- un élément de synchronisation supplémentaire (330) connecté à la sortie dudit circuit de détection logique (307) pour recevoir son horloge de la sortie dudit bloc de division par deux (302) et pour produire une sortie de charge synchronisée (319) ; et
- une pluralité de blocs de logique combinatoire (310, 311, 312) pour recevoir ladite sortie de charge (319) et pour produire des signaux de charge (LD1, LD2, LDn) pour lesdites cellules binaires (303, 304, 305) pour détecter l'état de tous les étages.

2. Diviseur de fréquence programmable optimisant la surface selon la revendication 1, dans lequel ledit circuit préprocesseur d'horloge (301) comprend un transistor de démarrage (M4) monté en parallèle aux transistors de commande (M1) pour assurer que ledit diviseur ne se met pas dans un état faux.

3. Diviseur de fréquence programmable optimisant la surface selon la revendication 1, dans lequel lesdites cellules binaires (303, 304, 305) comprennent :
- un circuit de division par deux ; et
- une pluralité de transistors connectés au circuit de division par deux pour charger les cellules binaires,
et où les cellules binaires sont adaptées pour délivrer la fréquence divisée si le signal de charge est inactif et pour délivrer un signal haut logique si le signal de charge est actif.

4. Diviseur de fréquence programmable optimisant la surface selon la revendication 1, dans lequel ladite logique combinatoire est conçue pour produire un signal de charge pour chacune desdites cellules binaires en utilisant un signal global, qui est produit pour plus d'un cycle d'horloge d'entrée.
